Europäisches Patentamt

European Patent Office

Office européen des brevets

(11) Veröffentlichungsnummer: **0 110 256**
**A1**

(12) **EUROPÄISCHE PATENTANMELDUNG**

(21) Anmeldenummer: 83111505.0

(51) Int. Cl.³: **G 03 F 7/26**

(22) Anmeldetag: 17.11.83

(30) Priorität: 26.11.82 DE 3243874

(43) Veröffentlichungstag der Anmeldung: 13.06.84
Patentblatt 84/24

(84) Benannte Vertragsstaaten: **AT BE CH DE FR GB IT LI NL SE**

(71) Anmelder: **HOECHST AKTIENGESELLSCHAFT,**
**Postfach 80 03 20, D-6230 Frankfurt am Main 80 (DE)**

(72) Erfinder: **Idstein, Hermann, Johannisberger Strasse 55,**
**D-6227 Oestrich-Winkel 2 (DE)**

(54) **Andruck- und Abhebeeinrichtung.**

(57) Die Erfindung betrifft eine Andruck- und Abhebeeinrichtung (1), die Andruckwalzen (15), eine Rakel (16) und Bürsten (20, 21) umfaßt, die in Führungsleisten (31) bzw. Lagern (40, 41) auf Innenseiten von Seitenschilden eines Verarbeitungsgeräts gelagert sind. Niederhalter (9, 9', 9'', 9''') sind an Tragrahmen (14, 14') mit schräg geneigten Langlöchern (10) mittels Schrauben (34) vertikal justierbar und über Lagerträger (12), auf denen Wälzlager (11) aufsitzen, längs verschiebbar gelagert. Schrauben (13) befestigen die Lagerträger an Seitenschilden. Eine Welle (3) mit Naben (2, 2'), an der ein Handhebel (23) angreift, verbindet die Tragrahmen. Die Naben sind über Befestigungsschrauben (27) mit Laschen (5, 5') verbunden, an denen mittels drehbarer Bolzen (28, 28') Verbindungslaschen (6, 6') gelagert sind, die mit Schraubbolzen (8) an den Tragrahmen drehbar angelenkt sind, die Abhebbügel mit Aussparungen (33) für die Antriebswalzen und die Bürsten tragen.

In der Arbeitsstellung drücken die Niederhalter die Andruckwalzen, die Rakel und die Bürsten gegen eine Druckplatte (38) oder eine Tischfläche (24), über welche die Druckplatte geführt ist, an.

Ein federbelasteter Positionsstift (25) sichert die Ruhestellung des Handhebels (23) gegen Herunterschwenken.

Andruck- und Abhebeeinrichtung

Die Erfindung betrifft eine Andruck- und Abhebeeinrichtung für hintereinander angeordnete Arbeitselemente in einem Verarbeitungsgerät für belichtete
Druckmaterialien, die im Durchlauf über eine Tischfläche geführt, entwickelt und gereinigt werden.

In Verarbeitungsgeräten für Druckplatten, fotoempfindlich beschichteten Papieren, Folien oder dgl. Materialien, die nach einer bildmäßigen Belichtung entwickelt werden, sind im allgemeinen Transport- und
Abquetscheinrichtungen aus zwei gegeneinander andrückbaren Walzen vorgesehen, die den Weitertransport der
Druckplatten und das gleichzeitige Abquetschen der
überschüssigen Entwicklerflüssigkeit, sonstiger Chemikalien für die Entwicklung sowie der Reinigungsflüssigkeit von den beiden Seiten des Druckmaterials bewerkstelligen. In Transportrichtung der Druckmaterialien durch das Verarbeitungsgerät gesehen, sind den
Transport- und Abquetscheinrichtungen häufig Rakeleinrichtungen vor- bzw. nachgeschaltet, die noch vorhandene Restflüssigkeitsmengen vor und nach den einzelnen Verarbeitungsstationen abrakeln, um so eine Verschleppung der jeweiligen Flüssigkeit in eine nachfolgende Verarbeitungsstation zu verhindern.

Die innerhalb der Entwicklerstation angeordneten rotierenden und oszillierenden Bürsten unterstützen bei
gleichzeitiger Einwirkung einer Entschichterflüssig-

HOECHST AKTIENGESELLSCHAFT
KALLE Niederlassung der Hoechst AG

- 2 -

keit die Aufentwicklung einer Druckplatte.

In der Praxis ist jedes dieser Arbeitselemente einzeln gelagert (DE-OS 23 36 122) und wird auch einzeln gegen das über die Tischfläche laufende Druckmaterial angedrückt. Ein gemeinsames Anheben bzw. Abheben der Arbeitselemente von der Anlagefläche ist nicht vorgesehen, sondern nur deren einzelnes An- bzw. Abheben.

Bei dieser Einrichtung ist nachteilig, daß zum Abheben der oberen Walzen, was vor längeren Stillstandzeiten, z.B. über Nacht oder über ein Wochenende, erfolgen muß, eine Vielzahl von Betätigungsgriffen zu bedienen ist, da jedem Ende jeder oberen Walze ein eigener Betätigungsgriff zugeordnet ist. Ihre Bedienung ist umständlich und zeitraubend, so daß die Versuchung besteht, diese Bedienung gelegentlich zu unterlassen. Verbleiben jedoch die Walzen über längere Stillstandzeiten aufeinandergepreßt, so können Deformierungen ihrer Oberflächen eintreten, welche einen sicheren und schonenden Transport der Druckplatten sowie eine einwandfreie Flüssigkeitsabquetschung, vor allem bei waagerechten Verarbeitungsanlagen, gefährden können.

Zum Stand der Technik gehört ebenfalls eine Einrichtung zum Entwickeln von Druckplatten mit paarweise angeordneten Rollen, deren Enden in Seitenschilden gelagert sind. Diese Seitenschilde sind so aufgeteilt und mittels einem dem oberen Seitenschild zugeordneten Drehpunkt und entsprechenden Hubelementen derart aus-

HOECHST AKTIENGESELLSCHAFT
KALLE Niederlassung der Hoechst AG

- 3 -

gerüstet, daß der komplette obere Teil der Seitenschilde bzw. der Verarbeitungszone einschließlich
aller oberen Walzen angehoben werden kann.

Diese Einrichtung ist verhältnismäßig aufwendig und erfordert einen großen Kraftaufwand der Bedienungsperson. Diese Anordnung ist nicht für solche Einrichtungen verwendbar, die eine Mehrzahl von Behandlungsstationen aufweisen, wobei jede Behandlungsstation als eine bauliche Einheit ausgebildet ist, die mit weiteren baulichen Einheiten zu der gesamten Einrichtung zusammengesetzt werden kann.

Aus der DE-AS 22 50 279 ist eine Verarbeitungseinrichtung für Druckplatten mit einem feststehenden Unterteil und mit einem gegenüber diesem um eine waagerechte Achse kippbaren Oberteil bekannt. Eine nach dem Schraubprinzip arbeitende elektrisch betriebene Hebevorrichtung ist an dem Oberteil befestigt und hebt dieses an bzw. senkt es ab, wobei die Hebevorrichtung mit auf Druck reagierenden Schaltmitteln in Verbindung steht, die an beiden Teilen der Verarbeitungsvorrichtung angebracht sind. Im Oberteil sind Walzen gelagert, die beim Abklappen des Oberteils mit diesem angehoben werden. Von Nachteil ist bei dieser Vorrichtung, daß die verschiedenen Flüssigkeiten von den Walzen in die angrenzenden Verarbeitungsstationen abtropfen können, da das Oberteil vom Unterteil nicht parallel angehoben, sondern nur schräg zu diesem aufgeklappt wird. Außerdem verdunstet verstärkt Entwickler durch das Öffnen der Verarbeitungsvorrichtung.

HOECHST AKTIENGESELLSCHAFT
KALLE Niederlassung der Hoechst AG

- 4 -

Aus der DE-OS 28 12 688 ist eine Entwicklungseinrichtung für Druckplatten mit paarweise, horizontal angeordneten oberen und unteren Walzen zum Transport der Druckplatten bekannt, wobei diese Walzen zum Abquetschen von an den Druckplatten haftenden Restflüssigkeiten dienen. Jede obere Andruckwalze weist an jedem Ende ein bezüglich der unteren Walze anhebbar und absenkbar angeordnetes Lager auf, das über eine Kniehebelanordnung betätigt wird. Die Betätigung der Lager der oberen Walzen erfolgt über je einen schwenkbaren Gabelkopf mit einem oberen und einem unteren Arm, dessen Schwenkachse parallel zur Druckplattentransportrichtung gerichtet ist. Der obere Arm wird durch die Kniehebelanordnung im abgesenkten Zustand des Lagers von oben auf das Lager gedrückt, während der untere Arm das Lager im angehobenen Zustand stützt. Ein erstes Ende jeder Kniehebelanordnung steht mit dem Gabelkopf in Verbindung und ein zweites Ende jeder Kniehebelanordnung steht mit einer allen Kniehebelanordnungen gemeinsamen drehbaren Schaltwelle in Verbindung, wobei die Schaltwelle parallel zur Druckplattentransportrichtung gelagert ist.

Bei entspannten, aber nicht auf Distanz gebrachten Andruckwalzen führen im allgemeinen eingetrocknete Entschichterflüssigkeit und/oder Gummierungsreste zu Verklebungen im Spaltbereich der Walzen. Derartige Verklebungen können Beschädigungen an den Oberflächen der Walzen und des Druckmaterials verursachen. Von Nachteil ist auch, daß die Rakeleinrichtung durch eingetrocknete Entschichterflüssigkeit mit der Anlagefläche verkleben kann, was beim Entnehmen der Rakeleinrichtung bzw. beim Durchlauf der folgenden Druckplatten zu Beschädigungen der Rakellippe führen kann. Im Fall von oszillierenden und/oder rotierenden Bürsten als Arbeitselemente in dem Verarbeitungsgerät ergibt sich der Nachteil, daß die Borsten der Bürsten beim Gerätestillstand über Nacht oder über das Wochenende belastet bleiben und nicht angehoben sind, so daß die gegen die Anlagefläche angedrückten Borsten nicht wieder in ihre entspannte Ausgangslage zurückfedern können, so daß die Borsten eine kürzere Lebensdauer besitzen als bei abgehobener Bürste zu erwarten wäre. Außerdem leidet durch die eintretende Deformierung der Borsten die Betriebssicherheit der Bürsten.

Aufgabe der Erfindung ist es, eine Andruck- und Abhebeeinrichtung für ein Verarbeitungsgerät von Druckmaterialien zu schaffen, die ein vollständiges Abtropfen der für die Entwicklung, Reinigung und/oder Gummierung verwendeten Chemikalien von den Arbeitselementen, wie Walzen, Rakel und Bürsten, ermöglicht und das Entnehmen dieser Arbeitselemente nach Beendigung des Arbeitsvorgangs aus dem Gerät zwecks Reinigung nicht erfordert.

Diese Aufgabe wird erfindungsgemäß dadurch gelöst, daß die Arbeitselemente zwischen Seitenschilden angeordnet und mit den Zapfenenden bzw. Achsenenden in Führungsleisten bzw. Lagern auf den Innenseiten der Seitenschilde gelagert sind, daß jedem Zapfen- und Achsenende eines Arbeitselements ein oberhalb des Arbeitselements befindlicher Niederhalter zugeordnet ist, der vertikal justierbar an einem der zu beiden Seiten der Arbeitselemente vorhandenen Tragrahmen befestigt ist und daß die Tragrahmen schräg verlaufende Langlöcher aufweisen, in die Lagerträger eingreifen, welche mittels Befestigungsschrauben mit den Seitenschilden verbunden sind.

In Weiterbildung der Erfindung sind die Tragrahmen über eine Welle miteinander verbunden, auf der verdrehfest auf beiden Stirnseiten je eine Nabe aufsitzt, und an zumindest einer der Naben ist ein Handhebel befestigt, der verschwenkbar ist. Selbstverständlich kann auch an jeder der Naben ein Handhebel angebracht sein. Mit den beiden Naben sind mittels Befestigungsschrauben Laschen verbunden und an den Laschen sind über drehbare Bolzen Verbindungslaschen gelagert, die mit Schraubbolzen an den Tragrahmen drehbar angelenkt sind. Dabei wird die Schwenkbewegung des Handhebels in eine Drehbewegung der Laschen sowie der Verbindungslaschen um die Welle umgesetzt und diese Drehbewegung löst eine zwangsweise Verschiebung der Tragrahmen aus. Diese zwangsweise Verschiebung der Tragrahmen löst deren Schrägbewegung über die geneigten Langlöcher aus, die schiefe Ebenen für das Abrollen an lagefesten Wälzlagern bilden, die auf den Lagerträgern innerhalb der Langlöcher aufsitzen.

HOECHST AKTIENGESELLSCHAFT
KALLE Niederlassung der Hoechst AG

- 7 -

Die weitere Ausgestaltung der Erfindung ergibt sich
aus den Merkmalen der Ansprüche 6 bis 10.

Mit der Erfindung werden die Vorteile erzielt, daß
sämtliche Andruckwalzen durch eine zentrale Bedienungsmöglichkeit entlastet und auf Distanz zu den darunter
liegenden Transportwalzen gebracht werden. Dadurch
sind Unrundheiten an den Oberflächen der Walzen infolge bleibender Verformung ausgeschlossen, da in der
Ruhestellung des Verarbeitungsgeräts die Oberflächen
der Walzen stets voneinander getrennt sind. Bei entspannten, aber nicht auf Distanz gebrachten angehobenen Andruckwalzen bekannter Andrucksysteme führen eingetrocknete Entschichter- und/oder Gummierungsreste zu
Verklebungen im Spaltbereich der Andruck- und Transportwalzen und können Anlaß zu Beschädigungen an den
Walzen- und Druckmaterilienoberflächen sein.

Von Vorteil ist weiterhin, daß der Andruck der Rakel
an die Oberfläche des durchlaufenden Druckmaterials
automatisch erfolgt, ebenso die Abhebung derselben von
der Anlagefläche, wodurch ein Verkleben der Rakellippe
mit der Anlagefläche durch eingetrocknete Entschichterflüssigkeit ausgeschlossen ist. Durch das zwangsgeführte Abheben der Rakel beim Abschalten des Verarbeitungsgeräts werden auch bleibende Verformungen der
Rakellippe verhindert. Durch das Anheben der oszillierenden und/oder rotierenden Bürste werden beim Gerätestillstand die Borsten entlastet, so daß die einzelnen
Borsten wieder in ihre Ausgangslage zurückfedern kön-

HOECHST AKTIENGESELLSCHAFT
KALLE Niederlassung der Hoechst AG

- 8 -

nen. Dadurch ergibt sich bei den Bürsten eine wesentlich höhere Lebensdauer als bei bekannten Verarbeitungsgeräten und außerdem erhöht sich auch deren Betriebssicherheit, da die Borsten nicht bleibend verformt sind.

Von Vorteil ist auch, daß zeitaufwendige Einstellarbeiten am Verarbeitungsgerät weitgehend unterbleiben können, da die Arbeitselemente der Andruck- und Abhebeeinrichtung außerhalb des Verarbeitungsgerätes montiert und einjustiert werden können und einer Nacheinstellung nicht bedürfen. Der Andruck der einzelnen Arbeitselemente an die Antragsfläche bzw. an die über die Antragsfläche transportierten Druckmaterialien kann in einfacher Weise auf die jeweils notwendigen Erfordernisse eingestellt werden.

Durch das Abheben aller Arbeitselemente von der Anlagefläche nach Beendigung des Verarbeitungsvorgangs tropfen die Chemikalienreste von den Arbeitselementen ohne Rückstände ab, so daß eine Reinigung zwischen den einzelnen Verarbeitungsvorgängen, die in bestimmten Zeitabständen ablaufen, weitgehend entfällt, wodurch der Wartungsaufwand erheblich verringert wird.

Die Erfindung wird im folgenden anhand eines zeichnerisch dargestellten Ausführungsbeispiels näher beschrieben.

Es zeigen:

Fig. 1  eine schematische Gesamtansicht der erfindungsgemäßen Andruck- und Abhebeeinrichtung in
der Andruckstellung der Arbeitselemente,

Fig. 2  eine schematische Gesamtansicht der Andruck-
und Abhebeeinrichtung nach Fig. 1 in der abgehobenen Ruhestellung,

Fig. 3  eine Teildraufsicht der Andruck- und Abhebeeinrichtung nach der Erfindung,

Fig. 3A  eine Ansicht einer Rakel der Andruck- und Abhebeeinrichtung,

Fig. 4  eine Schnittansicht der Andruck- und Transportwalzen und deren Lagerung in den Seitenschilden der Andruck- und Abhebeeinrichtung,
und

Fig. 5 und 6  Einzelheiten im Ausschnitt der Andruck-
und Abhebeeinrichtung im Bereich der Andruck-
und Transportwalze in der Arbeits- und der
Ruhestellung der Einrichtung.

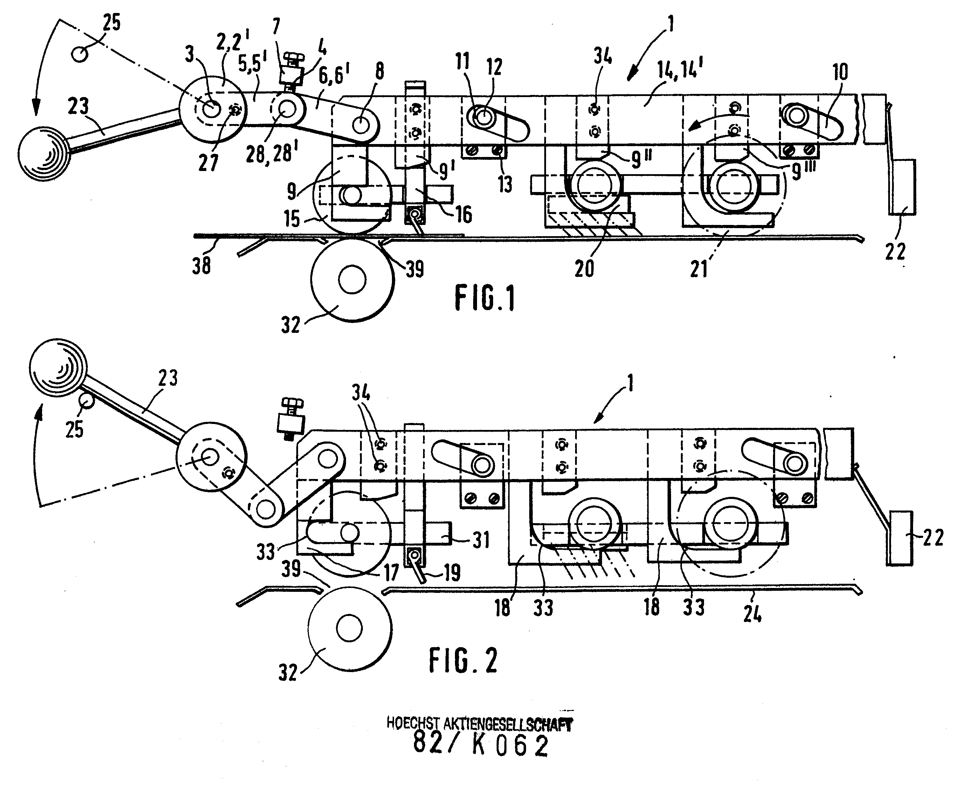

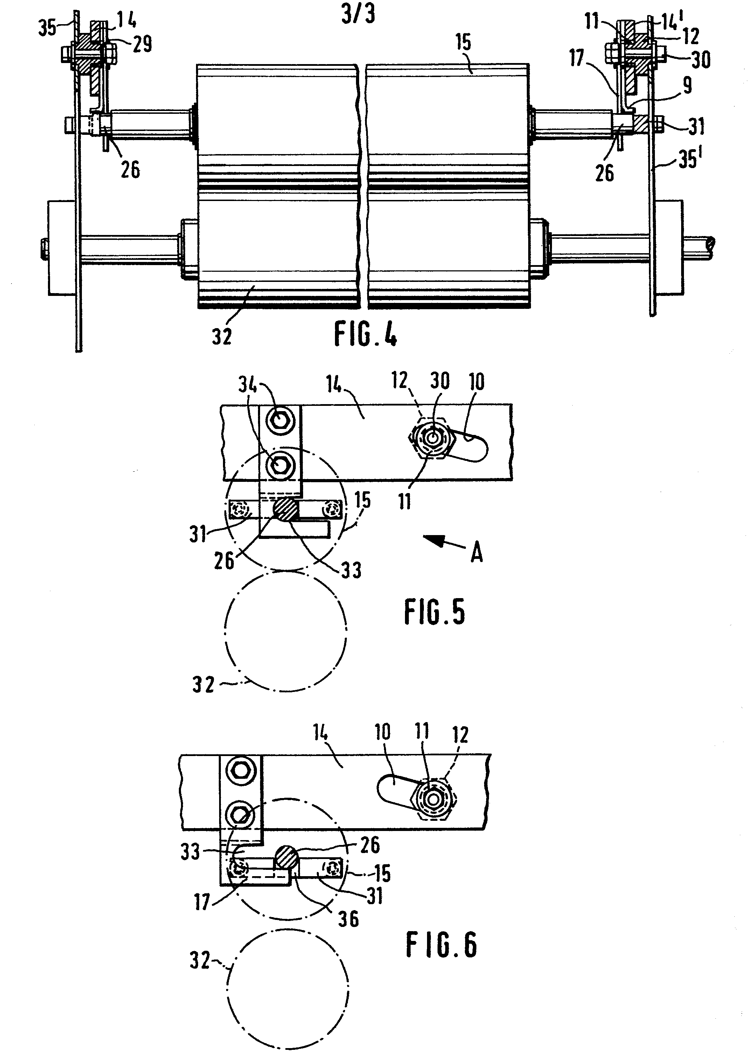

Fig. 1 zeigt die Seitenansicht einer Andruck- und Abhebeeinrichtung 1 in der Arbeitsstellung, in der die
hintereinander zwischen Tragrahmen 14,14' (vgl. Fig. 4)
angeordneten Arbeitselemente wie Andruckwalze 15,
eine Rakel 16 sowie Bürsten 20,21 gegen ein durchlaufendes Druckmaterial, beispielsweise eine Druckplatte 38 bzw. eine Tischfläche 24, die als Anlagefläche
für das durchlaufende Druckmaterial dient, anliegen.
Die Andruck- und Abhebeeinrichtung 1 ist Bestandteil eines Verarbeitungsgeräts für belichtete Druckmaterialien, die im Durchlauf über die Tischfläche 24 geführt, entwickelt, gereinigt und eventuell gummiert werden. Über die Länge der Tischfläche 24 sind im allgemeinen mehrere Verarbeitungsstationen mit paarweise angeordneten Transport- und Andruckwalzen vorgesehen, jedoch ist in den Zeichnungen nur ein einziges Paar dargestellt, bei dem der Andruckwalze 15 eine Transportwalze 32 gegenüberliegt, die durch eine Öffnung 39 in die Tischfläche 24 hineinragt. In der Arbeitsstellung ist die Andruckwalze 15 an die Transportwalze 32 angedrückt, während in der Ruhestellung die Andruckwalze 15 von der Transportwalze 32 abgehoben ist. Die Tragrahmen 14,14' sind über eine Welle 3 miteinander verbunden, auf der verdrehfest auf beiden Stirnseiten je eine Nabe 2,2' aufsitzt. Ein Handhebel 23 ist verschwenkbar an einer der Naben 2 bzw. 2' befestigt. Anstelle eines einzigen Handhebels 23 können auch zwei Handhebel vorgesehen werden, von denen jeweils einer an einer Nabe angebracht ist und die durch die Welle 3 miteinander verbunden sind.

An den beiden Naben 2,2' sind jeweils Laschen 5,5' mittels Befestigungsschrauben 27,27' montiert. An den rechten Enden der Laschen 5,5' in Fig. 1 sind mit Hilfe zweier drehbarer Bolzen 28,28' Verbindungslaschen 6,6' gelagert, die mit Schraubbolzen 8,8' an den Tragrahmen 14,14' drehbar angelenkt sind. Die Laschen 5,5' bilden zusammen mit den Verbindungslaschen 6,6' einen Kniehebel, der in den Drehpunkten der Bolzen

28,28' verschwenkbar und knickbar ist. In Fig. 1 ist dieser Kniehebel, wenn der Handhebel 23 nach unten geschwenkt ist, um einen kleinen Betrag nach oben so ausgeknickt, daß beide Bolzen 28,28' gegen Anschlag- und Justierschrauben 4,4' anliegen, die in Gegenlagern 7,7' an den Seitenschilden 35,35' eingreifen. Der ausgeknickte Kniehebel wird durch die Rückstellkraft der gegen die Tischfläche 24 angedrückten Arbeitselemente 15,16,20 und 21 in seiner ausgeknickten Position gehalten.

In dieser gesicherten Position drücken die einzelnen Niederhalter 9,9',9" und 9"', die an den Tragrahmen 14 bzw. 14' justierbar angeschraubt sind, die verschiedenen Arbeitselemente wie die Andruckwalze 15, die Rakel 16 und die Bürsten 20,21 in die Arbeitsstellung. Die Niederhalter 9,9',9",9"' sind mittels Schrauben 34 an den Innenseiten der Tragrahmen 14,14' befestigt.

Der Andruckwalze 15 ist die Rakel 16 nachgeordnet, deren Rakellippe 19 schräg gegen die Oberfläche der Druckplatte 38 anliegt. Die nachfolgende Bürste 20 ist beispielsweise eine oszillierende Bürste, während die Bürste 21 eine rotierende Bürste ist. Die Reihenfolge der Bürsten kann auch vertauscht sein oder anstelle der oszillierenden Bürste kann eine weitere rotierende Bürste vorgesehen sein.

Im allgemeinen sind zusätzlich zu den dargestellten Arbeitselementen noch weitere Walzenpaare und Rakel,

- 12 -

die jedoch aus Gründen der besseren Übersichtlichkeit nicht gezeichnet sind, vorhanden.

In den Tragrahmen 14,14' ist eine Anzahl schräg geneigter Langlöcher 10 vorhanden, in die Lagerträger 12 eingreifen, die durch Befestigungsschrauben 30 durchsetzt sind. Die Arbeitselemente 15,16,20 und 21 sind zwischen den Seitenschilden 35,35' angeordnet und mit den Zapfenenden 26 bzw. den Achsenenden in Führungsleisten 31 bzw. Lagern 40,41 auf den Innenseiten der Seitenschilde 35,35' gelagert. Die an den Tragrahmen 14,14' justierbar angeordneten Niederhalter befinden sich oberhalb der Zapfen- und Achsenenden der Arbeitselemente.

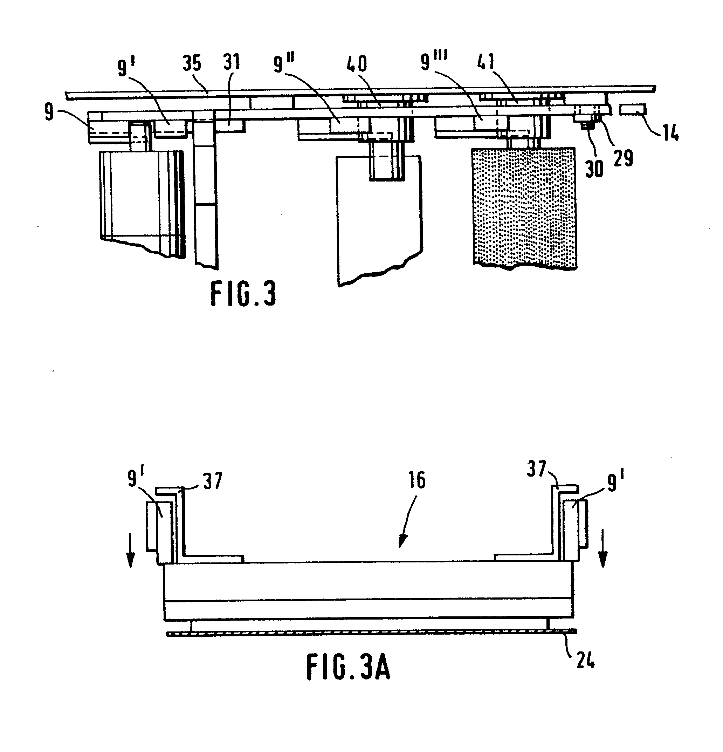

Die Lagerträger 12 sind mittels Schrauben 13 an den Seitenschilden 35,35' befestigt. Auf den Lagerträgern 12 sitzen Wälzlager 11 auf, über welche die jeweils eine schiefe Ebene bildenden Langlöcher längs verschiebbar sind. Die Tragrahmen 14,14' sind mittels Anlaufscheiben 29 und den Befestigungsschrauben 30 (vgl. Fig. 3) gegen axiales Verschieben gesichert.

An den Tragrahmen 14,14' sind Abhebbügel 17 für die Andruckwalze 15 und Abhebbügel 18 für die Bürsten 20,21 befestigt. Die Abhebbügel weisen eine abgerundete Aussparung 33 auf, deren unterer Schenkel eine geringe Distanz zu den Zapfen- bzw. Achsenenden der Andruckwalze 15 bzw. der Bürsten 20,21 in der Arbeitsstellung aufweisen.

Fig. 2 zeigt die Ruhestellung der Andruck- und Abhebe-einrichtung 1, in welcher der Handhebel 23 hochgeschwenkt ist und durch einen federbelasteten Positionsstift gesichert ist, gegen den die Unterkante des Handhebels 23 anliegt. Dieser Positionsstift 25 muß bei dem Übergang von der Ruhestellung in die Arbeitsstellung zunächst ausgerastet werden, bevor der Handhebel 23 niedergedrückt werden kann. In der Ruhestellung sind die Arbeitselemente von der Tischfläche 24 abgehoben und in einem Abstand von dieser angeordnet, so daß Restchemikalien unbehindert von den Arbeitselementen abtropfen können. Dadurch wird sichergestellt, daß es weder zu einem Ankleben der Rakellippe 19 auf der Tischfläche 24 noch zu einer Verklumpung des Spaltes zwischen der Andruckwalze 15 und der Transportwalze 32 kommt und darüberhinaus wird ein Festkleben der Borsten der Bürsten 20 und 21 bzw. eine Verformung der Borsten durch Anlegen an der Tischfläche 24 verhindert.

Die Endfläche des einen Tragrahmens steht in Berührung mit einem Kontrollschalter 22, der entsprechend der jeweiligen Stellung der Tragrahmen ein- und ausgeschaltet ist. In der Ruhestellung der Tragrahmen 14,14', wie sie in Fig. 2 dargestellt ist, ist der Kontrollschalter geöffnet, so daß er ein Starten der Arbeitselemente nicht zuläßt, da deren Antriebsquelle abgeschaltet ist.

In der Draufsicht nach Fig. 3 sind die Lagerung der Arbeitselemente in den Führungsleisten 31 und in den Lagern 40,41 sowie die Niederhalter 9 bis 9"' dargestellt.

Fig. 4 zeigt eine Teilansicht der Andruck- und Abbhebeeinrichtung 1, nämlich die Andruckwalze 15 sowie
die Transportwalze 32 in der Arbeitsstellung, in der
die Walzen gegeneinander gedrückt sind. Die Transportwalze ist mit ihren Achsenenden in nicht näher bezeichneten Lagerschalen an den Außenseiten der Seitenschilde 35,35' gelagert und ihre Achse ist über das
rechte Seitenschild 35' hinaus zu einem nicht dargestellten Antriebsmotor verlängert.

Die Zapfenenden 26 der Andruckwalze 15 sind in den
Führungsleisten 31 gelagert, die an den Innenseiten
der Seitenschilde 35,35' befestigt sind. Jeder der
Niederhalter 9 liegt mit seinem abgewinkelten Ende auf
der Oberseite des zugehörigen Zapfenendes 26 auf. Der
Abhebbügel 17 liegt an dem Niederhalter 9 an und seine
Aussparung 33 umfaßt das Zapfenende 26 in der Arbeitsstellung, wie aus Fig. 5 ersichtlich ist. Die Befestigungsschrauben 30 durchsetzen die Lagerträger 12 und
werden durch Muttern an den Innenseiten der Tragrahmen
14,14' gegen axiale Verschiebungen gesichert.

Die Figuren 5 und 6 zeigen Details der Lagerung der
Andruckwalze 15 in der Arbeits- und der Ruhestellung
der Andruck- und Abhebeeinrichtung 1. Wie aus Fig. 5
ersichtlich ist, umfaßt in der Arbeitsstellung die
Aussparung 33 zur Gänze das Zapfenende 26 der Andruck-

- 15 -

walze, wobei der untere Schenkel eine geringe Distanz
zum Zapfenende 26 aufweist. Der Lagerträger 12 mit dem
darauf aufsitzenden Wälzlager 11 befindet sich am oberen Ende des Langlochs 10.

In der in Fig. 6 dargestellten Ruhestellung hat sich
der Tragrahmen 14 von rechts unten nach links oben in
Richtung des Pfeils A in Fig. 5 bewegt, so daß sich
nunmehr der Lagerträger 12 zusammen mit dem darauf
aufsitzenden Wälzlager 11 am unteren Ende des Langlochs 10 befindet. Durch diese Bewegung verschiebt
sich der Abhebbügel 17 schräg nach oben, wodurch sein
unterer Schenkel das Zapfenende 26 aus einer Führungsnut 36 in der Führungsleiste 31 anhebt und somit ein
Spalt zwischen der Andruckwalze 15 und der Transportwalze 32 gebildet wird.

Auf der Oberseite der Rakel 16 ist ein Winkel 37 als
übergriff befestigt (Fig. 3A), gegen dessen horizontale Schenkel die Oberseite des Tragrahmens 14,14'
beim Anheben der Andruck- und Abhebeeinrichtung 1 anliegt und die Rakel 16 von der Tischfläche 24 abhebt.

Die Betriebsweise der Andruck- und Abhebeeinrichtung 1
ist folgende.

In der Ausgangsstellung sind die Andruckwalze 15, die
Rakel 16 und die Bürsten 20,21 mit ihren Zapfen- bzw.
Achsenenden in die Führungsleisten 31 des Verarbeitungsgerätes eingelegt. Die Andruck- und Abhebeeinrichtung 1 wird in ihre Arbeitsstellung dadurch ge-

HOECHST AKTIENGESELLSCHAFT
KALLE Niederlassung der Hoechst AG

- 16 -

bracht, daß die Bedienungsperson zuerst den zur Sicherung der Ruhestellung erforderlichen Positionsstift 25 ausrastet. Das nachfolgende Niederdrücken des Handhebels 23 bewirkt eine Drehung der angelenkten Naben 2 und 2'. Die ausgelöste Drehung verschiebt zwangsweise die Tragrahmen 14,14' nach rechts in Fig. 1. Die eingeleitete Längsverschiebung der Tragrahmen 14,14' löst über die schräg geneigten, schiefe Ebenen bildenden Langlöcher 10 durch Abrollen an den Wälzlagern 11 eine Schrägbewegung der Tragrahmen 14,14' von links oben nach rechts unten und der daran befestigten Niederhalter 9,9',9",9"' und der Abhebbügel 17 und 18 aus. In der Arbeitsstellung liegt die Andruckwalze 15 an der Transportwalze 32 an bzw. an der Oberfläche des Druckmaterials, wie der Druckplatte 38 an, die sich gerade im Spalt zwischen der Andruckwalze 15 und der Transportwalze 32 befindet. Des weiteren sind die Rakellippe 19 an die Oberfläche der Druckplatte 38 bzw. an die Tischfläche 24, über welche die Druckplatte 38 geführt wird, angedrückt, ebenso die Borsten der Bürsten 20 und 21.

Die Andruck- und Abhebeeinrichtung 1 wird in die Ruhestellung gebracht, indem der Handhebel 23 angehoben wird, wodurch die Tragrahmen 14,14' von rechts unten nach links oben verfahren werden. Dabei wird der federbelastete Positionsstift 25 eingedrückt, der nachfolgend die Endposition des Handhebels 23 gegen Herunterschwenken sichert.

Die an den Tragrahmen 14,14' befestigten Anhebbügel 17 und 18 werden dabei gleichzeitig angehoben und bringen die verschiedenen Arbeitselemente, wie Andruckwalze 15, Rakel 16 und Bürsten 20 und 21 auf Distanz zu ihren Auflageflächen. Mit der beendeten Hubbewegung der Tragrahmen 14,14' nach links oben geben die Niederhalter 9,9',9" und 9"' alle Arbeitselemente an ihren Andruckenden frei und ermöglichen eine einfache Entnahme in Vertikalrichtung. Der geöfffnete Kontrollschalter 22 verhindert in dieser Lage ein Starten und dadurch eine mögliche Fehlbedienung des Verarbeitungsgerätes.

Bei Verwendung einer Einstell-Lehre ist es möglich, die beiden Tragrahmen 14,14' mit sämtlichen Niederhaltern 9,9',9",9"' und Abhebbügeln 17 und 18 außerhalb des Verarbeitungsgeräts zu montieren und einzujustieren, so daß zeitaufwendige Einstellarbeiten am Verarbeitungsgerät weitgehend unterbleiben können.

---

HOECHST AKTIENGESELLSCHAFT
KALLE Niederlassung der Hoechst AG

82/K 062                        - 18 -          15. November 1983
                                                WLK-DI.Z.-is


P a t e n t a n s p r ü c h e


1. Andruck- und Abhebeeinrichtung für hintereinander angeordnete Arbeitselemente in einem Verarbeitungsgerät für belichtete Druckmaterialien, die im Durchlauf über eine Tischfläche geführt, entwickelt und gereinigt werden, dadurch gekennzeichnet, daß die Arbeitselemente (15,16,20,21) zwischen Seitenschilden (35,35') angeordnet und mit den Zapfenenden (26) bzw. Achsenenden in Führungsleisten (31) bzw. Lagern (40,41) auf den Innenseiten der Seitenschilde gelagert sind, daß jedem Zapfen- und Achsenende eines Arbeitselements (15,16,20,21) ein oberhalb des Arbeitselements befindlicher Niederhalter (9,9',9",9"') zugeordnet ist, der vertikal justierbar an einem der zu beiden Seiten der Arbeitselemente vorhandenen Tragrahmen (14,14') befestigt ist und daß die Tragrahmen (14,14') schräg verlaufende Langlöcher (10) aufweisen, in die Lagerträger (12) eingreifen, welche mittels Schrauben (13) mit den Seitenschilden (35,35') verbunden sind.


2. Andruck- und Abhebeeinrichtung nach Anspruch 1, dadurch gekennzeichnet, daß die Tragrahmen (14,14') über eine Welle (3) miteinander verbunden sind, auf der verdrehfest auf beiden Stirnseiten je eine Nabe (2;2') aufsitzt, und daß an zumindest einer der Naben (2;2') ein Handhebel (23) befestigt ist, der verschwenkbar ist.

3. Andruck- und Abhebeeinrichtung nach Anspruch 2, dadurch gekennzeichnet, daß mit den beiden Naben (2,2') Laschen (5,5') mittels Befestigungsschrauben (27,27') verbunden sind und daß an den Laschen (5,5') über drehbare Bolzen (28,28') Verbindungslaschen (6,6') gelagert sind, die mit Schraubbolzen (8,8') an den Tragrahmen (14,14') drehbar angelenkt sind.

4. Andruck- und Abhebeeinrichtung nach den Ansprüchen 2 und 3, dadurch gekennzeichnet, daß die Schwenkbewegung des Handhebels (23) in eine Drehbewegung der Laschen (5,5') sowie der Verbindungslaschen (6,6') um die Welle (3) umgesetzt wird, und daß diese Drehbewegung eine zwangsweise Verschiebung der Tragrahmen (14,14') auslöst.

5. Andruck- und Abhebeeinrichtung nach Anspruch 4, dadurch gekennzeichnet, daß die zwangsweise Verschiebung der Tragrahmen (14,14') deren Schrägbewegung über die geneigten Langlöcher (10) auslöst, die schiefe Ebenen für das Abrollen an lagefesten Wälzlagern (11) bilden, die auf den Lagerträgern (12) innerhalb der Langlöcher (10) aufsitzen.

6. Andruck- und Abhebeeinrichtung nach Anspruch 1, dadurch gekennzeichnet, daß an den Tragrahmen (14,14') Abhebbügel (17,18) für die Arbeitselemente (15,16,20,21) befestigt sind, die eine abgerundete Aussparung (33) aufweisen, gegen die die Zapfen- bzw. Achsenenden der Arbeitselemente (15,16,20,21) in der Arbeitsstellung der Andruck- und Abhebeeinrichtung (1)
anliegen.

7. Andruck- und Abhebeeinrichtung nach Anspruch 1,
dadurch gekennzeichnet, daß die Arbeitselemente eine
Andruckwalze (15), eine Rakel (16) und Bürsten (20,21)
umfassen, die von Niederhaltern (9,9',9",9"') in der
Arbeitsstellung gegen eine Druckplatte (38) und die
Tischfläche (24) gedrückt werden.

8. Andruck- und Abhebeeinrichtung nach Anspruch 2,
dadurch gekennzeichnet, daß in der Ruhestellung der
Handhebel (23) durch einen federbelasteten Positionsstift (25) gesichert ist, gegen den die Unterkante des
Handhebels (23) anliegt.

9. Andruck- und Abhebeeinrichtung nach Anspruch 3,
dadurch gekennzeichnet, daß die Laschen (5,5') zusammen mit den Verbindungslaschen (6,6') einen Kniehebel
bilden, der in den Drehpunkten der Bolzen (28,28')
verschwenkbar und knickbar ist und daß in ein Gegenlager (7) an dem Seitenschild (35) eine Anschlag- und
Justierschraube (4) eingreift, gegen die der ausgeknickte Kniehebel anliegt, der durch die Rückstellkraft der gegen die Tischfläche (24) angedrückten
Arbeitselemente (15,16,20,21) in seiner ausgeknickten
Position gehalten ist.

10. Andruck- und Abhebeeinrichtung nach Anspruch 3,
dadurch gekennzeichnet, daß die Endfläche des einen

HOECHST AKTIENGESELLSCHAFT
KALLE Niederlassung der Hoechst AG

- 21 -

Tragrahmens (14,14') mit einem Kontrollschalter (22) in Berührung steht und diesen entsprechend der Stellung der Tragrahmen ein- und ausschaltet und daß der Kontrollschalter (22) in der Ruhestellung der Tragrahmen (14,14'), in der die Arbeitselemente (15,16,20,21) entlastet sind, geöffnet ist, so daß er ein Starten der Arbeitselemente verhindert.

---

0110256

FIG.1

FIG.2

HOECHST AKTIENGESELLSCHAFT 82/K062

0110256

FIG.3

FIG.3A

0110256

**FIG.4**

**FIG.5**

**FIG.6**

Europäisches
Patentamt

EUROPÄISCHER RECHERCHENBERICHT

0110256

Nummer der Anmeldung

EP 83 11 1505

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | US-A-4 349 932 (E. SCHÖRNIG) <br> * Spalten 2,3; Figuren 1,2 * | 1,7 | G 03 F 7/26 |
| D,A | EP-A-0 004 337 (HOECHST A.G.) <br> * Seiten 10-15; Figuren 1-14 * | 1 | |
| A | US-A-4 222 656 (R.E. HARRELL) <br> * Spalten 4-12; Figuren 1-9 * | 1 | |
| A | DE-A-2 326 122 (J. BECH) <br> * Spalten 4-9; Figuren 1-8 * | 1 | |

RECHERCHIERTE
SACHGEBIETE (Int. Cl. 3)

G 03 F 7/26
G 03 D 5/04
G 03 D 3/13
B 41 F 13/24
B 41 F 13/26
B 41 F 13/32
B 41 F 13/34

Der vorliegende Recherchenbericht wurde für alle Patentansprüche erstellt.

| Recherchenort | Abschlußdatum der Recherche | Prüfer |
|---|---|---|
| DEN HAAG | 08-03-1984 | BOEYKENS J.W. |